# EUROPÄISCHE PATENTANMELDUNG

(11) **EP 3 447 516 A1**
(43) Veröffentlichungstag der Anmeldung: **27.02.2019**
(21) Anmeldenummer: 17187767.3
(22) Anmeldetag: 24.08.2017
(51) Int. Cl.: G01R 33/36

(54) **LOKALSPULE MIT ADAPTIVER AKTIVIERUNG EINES VERSTÄRKERS**

(71) Anmelder: Siemens Healthcare GmbH, 91052 Erlangen (DE)
(72) Erfinder: Greim, Helmut, 91325 Adelsdorf (DE); Jahns, Karsten, 91054 Buckenhof (DE)

(57) **Zusammenfassung**

Die Erfindung betrifft eine Lokalspule (50) für einen Magnetresonanztomographen (1). Die Lokalspule (50) weist eine Energiesteuerung (56), einen Sensor (57) in Signalverbindung mit der Energiesteuerung (56) und einen Energieverbraucher (52,53,54) auf. Der Sensor (57) ist ausgelegt, einen Messwert aufzunehmen, der charakteristisch für eine vorbestimmte Umgebung ist. Die Energiesteuerung (56) ist ausgelegt, in Abhängigkeit von dem Messwert den Energieverbraucher (52,53,54) zu aktivieren.

## Beschreibung

Die Erfindung betrifft eine Lokalspule für einen Magnetresonanztomographen mit einem Energieverbraucher, der aktivierbar ist.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden. Die Empfangsantennen können auch in einer Patientenliege verbaut sein.

Die Empfangsantennen sind üblicherweise über eine Anschlussleitung mit einer Empfangseinrichtung des Magnetresonanztomographen verbunden, der empfangene Magnetresonanzsignale auswertet. Die Empfangsantennen weisen auch rauscharme Vorverstärker (low noise amplifier, LNA) auf, die die schwachen Magnetresonanzsignale vor der Übertragung über die Anschlussleitung verstärken. Der für den Betrieb der Vorverstärker erforderliche Strom wird ebenfalls über die gleichen oder separate Adern der Anschlussleitung übertragen. In der Lokalspule können auch lokale Oszillatoren und Mischer zur Frequenzumsetzung oder AD-Wandler zum Digitalisieren des empfangenen Signals vorgesehen sein.

Die Energieverbraucher erzeugen eine merkliche Verlustwärme, da insbesondere rauscharme Hochfrequenzverstärker und Mischer oder schnelle AD-Wandler nicht mit beliebig kleinen Strömen realisiert werden können. Die Verlustwärme der unmittelbar am Körper befindlichen Lokalspule erhöht noch ein Unwohlsein eines Patienten der bereits durch die eingestrahlte Hochfrequenzleistung ein Wärmeempfinden hat. Gleichzeitig steigt mit der Temperatur der Komponenten auch deren Rauschzahl. Eigentlich benötigt werden aber bei einer Lokalspulenmatrix wie der Spine-Spule nur jeweils die Antennenspulen, die sich im Field-of-View (FoV, Untersuchungsbereich) befinden.

Aus der Druckschrift DE 102016203255 ist ein Verfahren zur Positionsbestimmung für eine Lokalspule mittels Magnetfeldsensoren bekannt. Dabei ist das Ziel, die Position der Lokalspule als Ganzes in Bezug auf die Patientenliege möglichst genau zu bestimmen, um die empfangenen Daten genau zuordnen zu können. Die Erfassung erfolgt daher mit wenigen, aber genauen Sensoren für die Lokalspule als Ganzes durch den Magnetresonanztomographen.

Um jeweils einzelne Energieverbraucher ein- und auszuschalten ist aber eine Vielzahl von Leitungen zwischen Magnetresonanztomograph und Lokalspule erforderlich. Darüber hinaus müsste die Steuerung des Magnetresonanztomographen angepasst werden.

Es könnte daher eine Aufgabe der Erfindung sein, eine Lokalspule bereitzustellen, die die Erwärmung verringert.

Die Aufgabe wird durch eine erfindungsgemäße Lokalspule nach Anspruch 1 gelöst.

Die erfindungsgemäße Lokalspule für einen Magnetresonanztomographen weist eine Energiesteuerung auf. Als Energiesteuerung wird im Sinne der Erfindung jede elektrische Schaltung oder Prozessor angesehen, die in der Lage ist, auf ein vorbestimmtes Signal bzw. Signale an einem oder mehreren Signaleingängen der Energiesteuerung ein vorbestimmtes Ausgangssignal an einem Signalausgang der Energiesteuerung auszugeben und damit die nachfolgend beschriebene Funktionalität zu leisten.

Die erfindungsgemäße Lokalspule weist weiterhin einen Sensor in Signalverbindung mit der Energiesteuerung, insbesondere einem Signaleingang der Energiesteuerung auf.

Schließlich weist die erfindungsgemäße Lokalspule einen Energieverbraucher auf. Als Energieverbraucher im Sinne der Erfindung wird jede Vorrichtung angesehen, die elektrische Energie im Betrieb aufnimmt und zumindest teilweise in Wärme umsetzt. Beispielhafte Energieverbraucher einer Lokalspule sind rauscharme Vorverstärker, Mischer, AD-Wandler, Oszillatoren, Ausgangstreiber oder ähnliches.

Der Sensor ist dabei ausgelegt, einen Messwert aufzunehmen, der charakteristisch für eine vorbestimmte Umgebung ist. Dies kann wie in nachfolgenden Unteransprüchen im Detail angegeben ein Sensor für Magnetfelder sein, denkbar wären aber auch akustische, optische oder Hochfrequenzsensoren sein, die ein Pilotsignal erkennen, dass in der vorbestimmten Umgebung ausgestrahlt wird.

Die Energiesteuerung ist dabei ausgelegt, den Messwert über die Signalverbindung zu empfangen und in Abhängigkeit von dem Messwert den Energieverbraucher zu aktivieren. Im einfachsten Fall kann die Energiesteuerung beispielsweise ausgelegt sein, bei Überschreiten eines vorbestimmten Schwellwertes durch den Messwert, der von dem Sensor empfangen wird, das Ausgangssignal an dem Signalausgang zu ändern. Dies kann beispielsweise durch einen elektrischen Schalter die Energiezufuhr zu dem Energieverbraucher herstellen oder unterbrechen.

Auf vorteilhafte Weise ist die erfindungsgemäße Lokalspule in der Lage, eine vorbestimmte Umgebung mittels des Sensors zu erkennen und nur in dieser Umgebung die Energieverbraucher selbstständig zu aktivieren, sodass keine zusätzlichen Steuerleitungen zu der Lokalspule erforderlich sind und trotzdem eine unerwünschte Erwärmung vermieden wird.

Weitere vorteilhafte Ausführungsformen sind in den Unteransprüchen angegeben.

In einer möglichen Ausführungsform der erfindungsgemäßen Lokalspule ist der Sensor ein erster Magnetfeldsensor. Als Magnetfeldsensor im Sinne der Erfindung wird dabei ein Sensor bzw. Element angesehen, dass ein von einem Magnetfeld am Ort des Sensors abhängiges Ausgangssignal, insbesondere ein elektrisches Signal abgibt. Denkbar sind Sensoren, die ein Signal in Abhängigkeit von einem Betrag oder der Richtung des Magnetfeldes abgeben oder einer Kombination davon. Beispiele sind Hall-Sensoren oder Feldsonden. Vorzugsweise wird dabei das statische Magnetfeld des Feldmagneten 11erfasst, wobei Frequenzanteile des Magnetfeldes größer als 5 Hz, 10 Hz, 100 Hz oder 1 kHz nicht berücksichtigt werden.

Auf vorteilhafte Weise ermöglicht ein Magnetfeldsensor das bereits vorhandene B0-Feld des Feldmagneten zur Positionsbestimmung zu nutzen.

In einer denkbaren Ausführungsform der erfindungsgemäßen Lokalspule weist die Lokalspule einen zweiten Magnetfeldsensor in Signalverbindung mit der Energiesteuerung auf. Der erste und der zweite Magnetfeldsensor weisen dabei einen vorbestimmten Abstand zueinander auf. Die Energiesteuerung ist ausgelegt, mittels des ersten Magnetfeldsensors und des zweiten Magnetfeldsensors einen Magnetfeldgradienten zu ermitteln, beispielsweise in Richtung des Abstandes des ersten Magnetfeldsensors und des zweiten Magnetfeldsensors durch Differenzbildung der Messwerte des ersten und des zweiten Sensors. Die Energiesteuerung ist weiterhin ausgelegt, in Abhängigkeit von dem ermittelten Magnetfeldgradienten den Energieverbraucher zu aktivieren.

Auf vorteilhafte Weise werden durch die Differenz- bzw. Gradientenbildungen Änderungen des Absolutwertes oder der Empfindlichkeit der Sensoren, beispielsweise mit der Temperatur, ausgeglichen. Auch ist es möglich, dass sich zwar die Richtung des Magnetfeldes, nicht aber dessen Betrag ändert. Bei konstanter Ausrichtung der Lokalspule relativ zum Magnetresonanztomographen ist eine Positionsänderung damit auch in der Umgebung des Aufnahmebereichs erkennbar.

In einer möglichen Ausführungsform der erfindungsgemäßen Lokalspule ist der erste Magnetfeldsensor und/oder der zweite Magnetfeldsensor ausgelegt, einen Betrag einer Magnetfeldstärke zu bestimmen. Beispielsweise kann eine Feldsonde oder eine Kombination aus mehreren orthogonal angeordneten Hall-Sensoren eine Magnetfeldstärke unabhängig von der Orientierung zu dem Magnetfeld bestimmen.

Die Magnetfeldstärke bietet auf vorteilhafte Weise eine Möglichkeit, unabhängig von der relativen Orientierung eine Information über das Magnetfeld zu bestimmen.

In einer denkbaren Ausführungsform der erfindungsgemäßen Lokalspule sind der erste Magnetfeldsensor und/oder der zweite Magnetfeldsensor ausgelegt, eine Richtung und einen Betrag eines Magnetfeldes zu bestimmen. Beispielsweise ist es denkbar, dass der erste und/oder zweite Magnetfeldsensor mehrere Hallsensoren aufweist, die unter einem Winkel zueinander angeordnet sind, sodass Flächennormalen zu der leitenden Halbleiterschicht einen dreidimensionalen Raum aufspannen. Die einzelnen Sensoren liefern dabei Ausgabewerte, die eine Projektion des Magnetfeldvektors auf die Flächennormalen wiedergeben und damit Komponenten des Vektors entlang unterschiedlicher Achsen. Durch eine Verknüpfung, beispielsweise eine Summe der Quadrate der Komponentenwerte für eine rechtwinklige Anordnung der Hallelemente zueinander, kann daraus zusätzlich ein Betrag des Vektors bestimmt werden.

Auf vorteilhafte Weise kann über die Richtungsinformation auch bei nahezu konstantem Betrag eine Ortsinformation aus dem Magnetfeld bestimmt werden.

In einer möglichen Ausführungsform der erfindungsgemäßen Lokalspule ist der Energieverbraucher ein Vorverstärker und/oder eine AD-Wandler.

Vorverstärker und A/D-Wandler werden nur in den Zeiträumen benötigt, wenn von der jeweiligen Antennenspule auch Magnetresonanzsignale erfasst werden sollen. Befinden sich die Antennenspulen außerhalb des Aufnahmebereichs, so können auf vorteilhafte Weise der AD-Wandler und/oder Vorverstärker von der Energieversorgung abgetrennt werden, da keine für eine Bildgebung sinnvollen Messwerte erfassbar sind. Auf vorteilhafte Weise kann so eine unerwünschte Erwärmung durch die Verlustleistung von AD-Wandler bzw. Vorverstärker vermieden werden.

In einer denkbaren Ausführungsform der erfindungsgemäßen Lokalspule weist die Lokalspule eine Matrix an Antennenspulen mit jeweils mindestens einem Energieverbraucher und mindestens einem Sensor auf. In einer bevorzugten Ausführungsform handelt es sich bei dem Sensor um einen Magnetfeldsensor.

Gerade bei größeren Lokalspulen wie zum Beispiel einer Spine-Spule mit einer größeren Abmessung in z-Richtung, bei der zumindest eine Abmessung größer ist als der Durchmesser des Aufnahmebereichs, können nie alle Antennenspulen bei der Bilderfassung aktiv sein. Es ist dann von besonderem Vorteil, die nicht an der Bilderfassung beteiligten Energieverbraucher zu deaktivieren, wie beispielsweise die den nicht aktiven Antennenspulen zugeordnete AD-Wandler oder Vorverstärker, um eine Erwärmung des Patienten zu reduzieren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines erfindungsgemäßen Systems aus Magnetresonanztomograph, Empfangsantenne und Anschlussleitung.
- Fig. 2: eine schematische Darstellung einer Ausführungsform einer erfindungsgemäßen Lokalspule;
- Fig. 3: eine schematische Darstellung einer Ausführungsform einer erfindungsgemäßen Lokalspule.

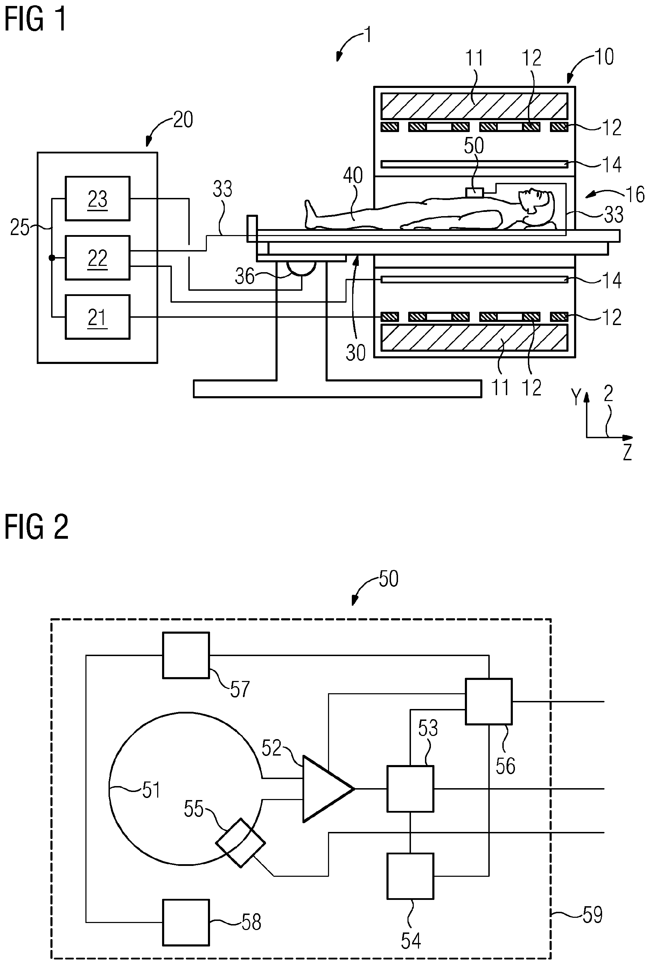

Fig. 1 zeigt eine schematische Darstellung einer Ausführungsform eines Magnetresonanztomographen 1 mit einer erfindungsgemäßen Lokalspule 50.

Die Magneteinheit 10 weist einen Feldmagneten 11 auf, der ein statisches Magnetfeld B0 zur Ausrichtung von Kernspins von Proben bzw. des Patienten 40 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 40 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 40 zu erzeugen. Dabei können Pulsleistungen im Bereich von Kilowatt erreicht werden. Die Anregungspulse können über die Körperspule 14 oder auch über eine lokale Sendeantenne in den Patienten 40 abgestrahlt werden.

Eine Steuerung 23 kommuniziert über einen Signalbus 25 mit der Gradientensteuerung 21 und der Hochfrequenzeinheit 22.

Auf dem Patienten 40 ist eine Lokalspule 50 angeordnet, die über eine erfindungsgemäße Anschlussleitung 33 mit der Hochfrequenzeinheit 22 verbunden ist.

Eine mögliche Ausführungsform einer erfindungsgemäße Lokalspule 50 ist in Fig. 2 schematisch im Detail dargestellt dargestellt.

Eine Antennenspule 51 empfängt das Magnetresonanzsignal, das anschließend durch einen rauscharmen Vorverstärker 52 (low noise amplifier, LNA) verstärkt wird. Mittels eines Mischers 53, der das MR-Signal mit Hilfe einer von einem lokalen Oszillator 54 bereitgestellten Oszillatorsignals in einen anderen Frequenzbereich umsetzt, wird das MR-Signal für die Übertragung über die Anschlussleitung 33 vorbereitet. Dabei kann der Mischer 53 auch eine Treiberschaltung aufweisen, um das MR-Signal an die Impedanz der Anschlussleitung 33 anzupassen.

Die Lokalspule 50 weist weiterhin eine Energiesteuerung 56 auf, die andere Einheiten der Lokalspule 50 wie beispielsweise Vorverstärker 52, Mischer 53 oder Oszillator 54 mit Energie versorgt oder zumindest deren Energieaufnahme über eine Signalverbindung steuert. Die Energie kann dabei von der Lokalspule 50 über eine Leitung oder auch drahtlos bezogen werden.

Ein erster Magnetfeldsensor 57 erfasst ein Magnetfeld in Bezug auf seine Magnetfeldstärke und gibt ein von der erfassten Magnetfeldstärke abhängiges Signal über eine Signalverbindung an die Energiesteuerung 56 weiter. In einer möglichen Ausführungsform kann die erfindungsgemäße Lokalspule 50 auch einen zweiten Magnetfeldsensor 58 aufweisen, der ebenfalls in Signalverbindung mit der Energiesteuerung 56 steht. Mit einem ersten Magnetfeldsensor 57 ist es der Energiesteuerung 56 beispielsweise möglich, das Magnetfeld mit einem vorbestimmten Schwellwert zu vergleichen. Dies kann z.B. durch eine analoge Energiesteuerung 56 mit einer Komparator-Schaltung erfolgen oder auch durch eine digitale Energiesteuerung 56.

Bei Überschreiten des Schwellwertes nimmt die Energiesteuerung 56 an, dass sich die Lokalspule im Aufnahmebereich der Magneteinheit 10 befindet, in dem das Magnetfeld am stärksten ist, und aktiviert die Energieverbraucher, die zur Bilderfassung erforderlich sind, wie zum Beispiel den Vorverstärker 52, den Mischer 53 und den Oszillator 54.

Es ist aber auch denkbar, dass die Energiesteuerung 56 die Signale des ersten Magnetfeldsensors 57 und des zweiten Magnetfeldsensors 58 auswertet, um aus einer Kombination auf eine Position relativ zu dem Magnetfeld des Feldmagneten 10 zu schließen. Durch eine Differenzbildung der Signale kann beispielsweise ein Gradient des Magnetfeldes B0 entlang eines Abstandes des ersten Magnetfeldsensors 57 und des zweiten Magnetfeldsensors 58 bestimmt werden. Ist der Gradient kleiner als ein vorbestimmter Schwellwert, kann beispielsweise angenommen werden, dass sich die Lokalspule 50 in einem Aufnahmebereich befindet, da dort das Magnetfeld homogen sein muss. In der Umgebung des Aufnahmebereichs hingegen fällt die Magnetfeldstärke ab, bis sie in großem Abstand zu der Magneteinheit 10 gegen Null geht. Die Energiesteuerung 56 aktiviert dann die Energieverbraucher, wenn der erfasste Wert für den Gradienten unter den vorbestimmten Schwellwert fällt. Auf vorteilhafte Weise ist es durch die Differenzbildung nicht erforderlich, dass die Magnetfeldsensoren absolut bezüglich der Magnetfeldstärke kalibriert sein müssen.

Weiterhin kann es sein, dass der erste Magnetfeldsensor 57 und/oder der zweite Magnetfeldsensor 58 nicht nur eine Magnetfeldstärke, sondern auch eine Richtung des Magnetfeldes erfassen. Dies ist zum Beispiel durch eine Kombination von drei Hallsensoren möglich, deren Halbleiterelemente so angeordnet sind, dass die Normalvektoren zur Ebene des Stromflusses ein dreidimensionales Koordinatensystem aufspannen. Die Richtung des Magnetfeldes kann der Energiesteuerung 56 weitere Kriterien zur Aktivierung der Energieverbraucher geben.

Es sind aber grundsätzlich auch andere Sensoren denkbar. Beispielsweise kann ein Pilotsignal in den Aufnahmebereich abgestrahlt werden wie ein zusätzliches Radiosignal, ein optisches Signal oder ein akustisches Signal, dass von dem Sensor erfasst wird und von der Energiesteuerung zur Entscheidung über die Aktivierung der Energieverbraucher genutzt wird.

Üblicherweise weist die Lokalspule in einer Ausführungsform auch ein Verstimmelement 55 auf, mit dem die Antennenspule 51 während eines Anregungspulses des Magnetresonanztomographen 1 vor Beschädigungen durch zu hohe Resonanzströme oder Spannungen geschützt wird.

Neben der in Fig. 2 dargestellten Ausführungsform sind auch andere Lokalspulen 50 mit anderen Energieverbrauchern erfindungsgemäß denkbar. Beispielsweise kann anstelle der analogen Übertragung der Magnetresonanzsignale eine Digitalisierung bereits in der Lokalspule 50 erfolgen. Zu den von der Energiesteuerung aktivierbaren Energieverbrauchern kann dann beispielsweise ein AD-Wandler gehören. Auch sind drahtlose Übertragungsvorrichtungen anstelle der Anschlussleitung 33 als erfindungsgemäße Energieverbraucher denkbar.

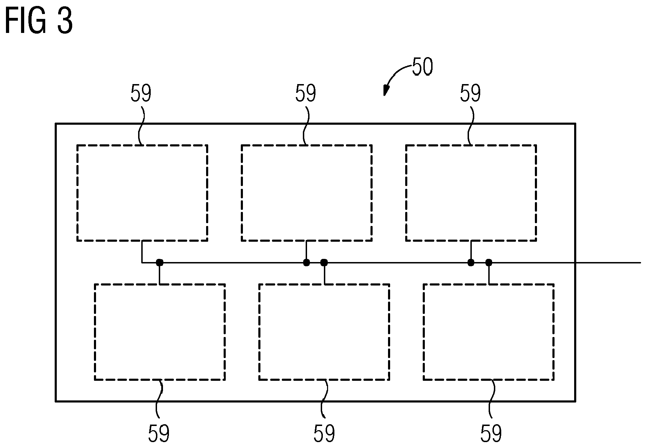

Fig. 3 stellt eine beispielhafte bevorzugte Ausführungsform der erfindungsgemäßen Lokalspule 50 dar. Dabei sind mehrere der in Fig. 2 dargestellten Antennenspulen mit den Energieverbrauchern und der jeweiligen Energiesteuerung 56 und Sensoren, im Folgenden zusammen als Matrixelemente 59 bezeichnet, zu einer Lokalspule 50 mit einer Matrix aus Antennenspulen 51 angeordnet. Dies kann beispielsweise eine Spine-Spule oder eine Extremitätenspule sein. Diese Lokalspulen 50 haben eine Abmessung die zumindest in einer Dimension größer als der Durchmesser des Aufnahmebereichs ist, sodass zumindest eine oder mehrere der Matrixeinheiten 59 sich jeweils nicht in dem Aufnahmebereich befinden.

Die jeweilige Energiesteuerung 56 deaktiviert dann vorteilhafterweise die Energieverbraucher der jeweiligen Matrixeinheit bzw. Matrixeinheiten 59. Dabei ist es denkbar, dass auch eine gemeinsame Energiesteuerung 56 für mehrere Matrixeinheiten 59 vorgesehen ist und deren jeweilige Magnetfeldsensoren 57, 58 auswertet und entsprechend die jeweiligen Energieverbraucher der jeweiligen Matrixeinheit 59 aktiviert bzw. deaktiviert, je nachdem ob sich die entsprechende Matrixeinheit 59 in dem Aufnahmebereich befindet.

Aufgrund der selbsttätigen Aktivierung im Aufnahmebereich bzw. Deaktivierung außerhalb des Aufnahmebereichs ist die erfindungsgemäße Lokalspule 50 in der Lage, ohne zusätzliche Steuerleitungen von dem Magnetresonanztomographen 1 einzelne Komponenten zu deaktivieren und auf diese Weise den Energieverbrauch und die Erwärmung zu verringern. Dies erfolgt transparent für den Magnetresonanztomographen 1, sodass keine Änderungen an der Schnittstelle zu der Lokalspule 50erforderlich ist und auch ältere Magnetresonanztomographen 1 mit neuen Lokalspulen 50 mit dieser Funktionalität versehen werden können.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Lokalspule für einen Magnetresonanztomographen (1), wobei die Lokalspule (50) eine Energiesteuerung (56), einen Sensor in Signalverbindung mit der Energiesteuerung (56) und einen Energieverbraucher aufweist, wobei der Sensor ausgelegt ist, einen Messwert aufzunehmen, der charakteristisch für eine vorbestimmte Umgebung ist und die Energiesteuerung (56) ausgelegt ist, in Abhängigkeit von dem Messwert den Energieverbraucher zu aktivieren.

2. Lokalspule nach Anspruch 1, wobei der Sensor ein erster Magnetfeldsensor (57) ist.

3. Lokalspule nach Anspruch 2, wobei die Lokalspule einen zweiten Magnetfeldsensor (58) in Signalverbindung mit der Energiesteuerung (56) aufweist, wobei die Energiesteuerung (56) ausgelegt ist, mittels des ersten Magnetfeldsensors (57) und des zweiten Magnetfeldsensors (58) einen Magnetfeldgradienten zu ermitteln und in Abhängigkeit von dem ermittelten Magnetfeldgradienten den Energieverbraucher zu aktivieren.

4. Lokalspule nach einem der Ansprüche 2 oder 3, wobei der erste Magnetfeldsensor (57) und/oder der zweite Magnetfeldsensor (58) ausgelegt sind, einen Betrag einer Magnetfeldstärke zu bestimmen.

5. Lokalspule nach einem der Ansprüche 2 oder 3, wobei der erste Magnetfeldsensor (57) und/oder der zweite Magnetfeldsensor (58) ausgelegt sind, eine Richtung und einen Betrag eines Magnetfeldes zu bestimmen.

6. Lokalspule nach einem der vorhergehenden Ansprüche, wobei der Energieverbraucher ein Vorverstärker (52) und/oder eine AD-Wandler ist.

7. Lokalspule nach einem der vorhergehenden Ansprüche, wobei die Lokalspule (50) eine Matrix an Antennenspulen (51) mit jeweils mindestens einem Energieverbraucher und mindestens einem Sensor aufweist.
